# EUROPÄISCHE PATENTSCHRIFT

(11) **EP 0 919 115 B1**
(45) Veröffentlichungstag und Bekanntmachung des Hinweises auf die Patenterteilung: **29.10.2003**
(21) Anmeldenummer: 97938792.5
(22) Anmeldetag: 18.08.1997
(51) Int. Cl.: H05K 9/00, C08G 77/34

(54) **LEITFÄHIGES DICHTUNGSMATERIAL UND DICHTUNGSPROFIL**
CONDUCTIVE SEALING MATERIAL AND PROFILED SEALING MEMBER
MATERIAU D'ETANCHEITE CONDUCTEUR ET JOINT D'ETANCHEITE PROFILE

(30) Priorität: 18.08.1996 DE 19634172
(43) Veröffentlichungstag der Anmeldung: 02.06.1999
(73) Patentinhaber: Kahl, Helmut, 12307 Berlin (DE); Tiburtius, Bernd, 14532 Kleinmachnow (DE)
(72) Erfinder: KAHL, Helmut, D-12307 Berlin (DE); GIELNIK, Karl, D-12249 Berlin (DE); TIBURTIUS, Bernd, D-14532 Kleinmachnow (DE)
(74) Vertreter: Eisenführ, Speiser & Partner
(86) Internationale Anmeldenummer: DE9701818
(87) Internationale Veröffentlichungsnummer: WO98008364

(56) Entgegenhaltungen:
- EP-A- 0 629 114
- DE-A- 3 934 845
- DE-A- 3 936 534
- GB-A- 2 115 084
- GB-A- 2 242 485
- GB-A- 2 257 976

## Beschreibung

Die Erfindung betrifft ein leitfähiges Dichtungsmaterial gemäß dem Oberbegriff des Anspruchs 1 sowie ein aus diesem Material gefertigtes Dichtungsprofil. Ein Dichtungsmaterial und ein aus diesen Material gefertigtes Dichtungsprofil sind aus der GB 2 242 485 A bekannt.

Elektrisch leitfähige Dichtungsmaterialien auf Silicon-Basis mit leitfähiger Füllung zur Herstellung von Gehäusedichtungen mit elektromagnetischer Abschirmwirkung an Ort und Stelle ("mold-in-place") sind seit langem bekannt und spätestens mit dem millionenfachen Einsatz von Mobiltelefonen ein Massenprodukt geworden.

Sie wurden früher insbesondere zum verklebenden Abdichten der Einzelteile von Abschirmgehäusen oder zum Aufkleben vorgefertiger Abschirmdichtungen während der Gehäusemontage eingesetzt und in ihren Eigenschaften entsprechend eingestellt. Zur Art und Weise der Herstellung solcher Dichtungen und zu entsprechenden Produkten wird auf den frühen Firmenprospekt 8565/0 "Conductive Materials and Products" (1970) oder das Datenblatt CS-723 "Conductive Caulking Sytems" (1972) der Fa. Tecknit, USA, das Technical Bulletin 46 "CHO-BOND 1038" (1987) der Fa. Comerics, USA, sowie die DE-A-39 36 534 und die GB-A-2 115 084 hingewiesen.

Das Verkleben von Abschirmgehäusen bei der Montage hat - neben erheblichen fertigungstechnischen und logistischen Nachteilen - den entscheidenden Gebrauchswertnachteil, daß die Gehäuse sich nach der Montage nur unter Zerstörung der Dichtung (und Abschirmung) wieder öffnen lassen.

Aus der DE-A-39 34 845 ist eine mehrteilige Abschirmdichtung bekannt, die aus einem elastischen Träger und einer hoch leitfähigen Deckschicht besteht und sowohl eine Vorfertigung von Gehäuseteilen mit Dichtung vor der Montage als auch ein wiederholtes Öffnen des Gehäuses nach dem erstmaligen Verschließen erlaubt. Die Herstellung der Dichtung ist aber aufwendig.

Es hat sich daher in der Massenproduktion das Verfahren nach der EP-B-0 629 114 durchgesetzt, bei dem das leitfähige Material in einem pastösen Ausgangszustand derart mittels Druck aus einer Nadel oder Düse direkt auf ein Gehäuseteil aufgebracht wird und sich dort unter Anhaften an dessen Oberfläche elastisch verfestigt, daß sich ein zugleich leitfähiges und elastisches Abschirmprofil ausbildet, dessen Profilgestalt über die geeignete Wahl der Querschnittsform und -größe und Abtastgeschwindigkeit der Nadel bzw. Düse sowie durch die Einstellung der Materialeigenschaften wie Viskosität, Thixotropie und Erhärtungs- bzw. Vernetzungsgeschwindigkeit bestimmt wird. Dieses Abschirmprofil weist auch bei mehrfachem Öffnen und Wiederverschließen des Gehäuses eine gute Beständigkeit auf.

Im Zuge des immer weiter voranschreitenden Masseneinsatzes und der sinkenden Preise von elektronischen Geräten, die nur mit hochwirksamer Abschirmung sicher funktionieren, unterliegt die Herstellung von Abschirmgehäusen einem hohen Kostendruck, der sich unter anderem im Einsatz kostengünstiger Gehäusematerialien und dem Wunsch nach größeren Fertigungstoleranzen für die Gehäuseteile ausdrückt. In diesem Umfeld besteht ein verstärkter Bedarf nach in ihren mechanischen Eigenschaften verbesserten, insbesondere relativ weichen, hochgradig deformierbaren Abschirmdichtungen, der mit den bekannten Dichtungsmaterialien nicht befriedigt werden kann.

Ein ähnlich motivierter, wenn auch quantitativ geringerer Bedarf besteht für wärmeleitende Dichtungen mit verbesserten mechanischen Eigenschaften.

Der Erfindung liegt deshalb die Aufgabe zugrunde, ein elektrisch und/oder thermisch hoch leitfähiges Dichtungsmaterial anzugeben, das die Herstellung eines Dichtungsprofils vom "mold-in-place"-Typ mit verbesserten und in einem breiten Wertebereich leicht einstellbaren mechanischen Eigenschaften, insbesondere sehr gutem Haftvermögen und wahlweise geringer Härte bzw. hoher Deformierbarkeit, erlaubt.

Die Aufgabe wird im Hinblick auf ein Dichtungsmaterial gemäß dem Oberbegriff des Anspruchs 1 durch die im kennzeichnenden Teil dieses Anspruchs angegebenen Merkmale und im Hinblick auf das Dichtungsprofil durch die Merkmale der Ansprüche 7 bzw. 9 gelöst.

Die Erfindung schließt - was den Materialaspekt angeht - den grundlegenden Gedanken ein, einem hochgradig metallisch gefüllten vernetzbaren, durch die Vernetzung aushärtenden Silikonkautschuk unter Bildung eines gelartigen bis flüssigen Zustandes ein langkettiges, nichtvernetzendes Siloxan beizumischen. Das aus dieser Mischung gebildete elektrisch und/oder thermisch leitfähige Dichtungsprofil zeichnet sich durch hohe Haftfestigkeit auf der Unterlage sowie eine auf geringe Werte einstellbare Shore A-Härte und hohen möglichen Deformationsgrad aus.

Der Anteil des langkettigen, nicht oder allenfalls schwach vernetzenden Siloxans (Siliconöls) an der Gesamtmischung - einschließlich metallischer und/oder anorganischer Füllung - beträgt mindestens 1 Masse-%. Bei kleineren Anteilen ändern sich die mechanischen Eigenschaften gegenüber einer reinen Siliconkautschuk-Basis nicht wesentlich.

Bei einem Anteil von mehr als 3 Masse-% des nicht-vernetzenden Siloxans nimmt das pastöse Material zunehmend gelartige Konsistenz an, die eine hochproduktive und hochqualitative formgeberfreie Bildung eines formbeständigen Dichtungsprofils durch Extrudieren aus einer Nadel oder Düse erlaubt, die direkt über eine zu dichtende Fläche geführt wird. Relativ weiche und dennoch mechanisch ausreichend beständige EMI-Abschirmprofile wurden mit hochgradig (zu über 50 Masse-%) metallpulvergefüllten Materialien extrudiert, die neben ca. 15 - 20 Masse-% vernetzbaren Siliconanteilen (handelsüblichen Ein- oder Zweikomponentenmischungen) etwa 5 Masse-% difunktionelles nicht-vernetzendes Siloxan, beispielsweise (Poly-)Dimethylsiloxan mit Methyloder Hydroxylendgruppen, mit einer Viskosität im Bereich zwischen 10 und 10³ mPa.s enthalten.

Die Beimischung des als solchen nicht-vernetzenden längerkettigen Siloxans ergibt für das Material nach Aushärtung der vernetzbaren Siliconkomponente (durch Luftfeuchtigkeit, Wärme oder Strahlung) eine weitmaschig vernetzte Struktur mit einer gewissen Plastizität, deren Grad über das Mischungsverhältnis vorbestimmt werden kann. Zur Bildung hochgradig plastischer Dichtungen für spezielle Anwendungen, wo nur geringe Anforderungen hinsichtlich der Formbeständigkeit bestehen, kann der Anteil der nicht-vernetzenden Komponente bis zu einem Vielfachen des Anteils der vernetzbaren Komponente erhöht sein.

Die wahlweise zusätzliche Zugabe eines organischen Lösungsmittels dient zum einen der Optimierung der Verarbeitungseigenschaften des Materials und kann zum anderen die Gebrauchseigenschaften der fertigen Profils positiv beeinflussen. Sie bewirkt gewissermaßen ein "Aufschwemmen" der Matrixmaterials, erleichtert insbesondere das Mischen der Komponenten und verbessert die Benetzung. Gute Ergebnisse wurden diesbezüglich mit Anteilen zwischen 5 und 20 Masse-% Benzin und/oder Toluol erzielt.

Der Lösungsmittelanteil kann für spezielle Anwendungen - etwa für durch Aufrakeln, Aufsprühen oder Tauchen auf bzw. von Gehäusekanten erzeugte "mold-in-place"-Dichtungen - indes auch erheblich höher liegen und bis zu einem Mehrfachen des Anteils der Basis- bzw. Matrix-Mischung betragen.

In einer für bestimmte Anwendungen vorteilhaften Fortbildung kann des weiteren ein Siliconharz-Anteil im Dichtungsmaterial vorgesehen sein, bevorzugt ein Anteil von über 3 Masse-% einer Lösung einer handelsüblichen warm- oder strahlungshärtenden Harzkomponente.

Dichtungsmaterial mit hoher elektrischer Leitfähigkeit zur Herstellung von EMI-Abschirmungen ist insbesondere mit einem hohen Anteil von Silberpulver oder einem versilberten Pulver eines anderen Metalls (Nickel, Kupfer o.ä.) gefüllt. Der Metallgehalt liegt typischerweise bei über 25 Masse-%, zur kostengünstiger Erzielung hoher Abschirmwirkungen bei Mobiltelefonen o.ä. sogar weit über 50 Masse-%, bezogen auf die Masse der Silicon-Siliconöl-Metall-Mischung.

Materialien zum Einsatz für hochgradig wärmeleitende Dichtungen können neben Metallpulver - insbesondere dann, wenn die Dichtung nicht elektrisch leitfähig sein soll - eine Füllung aus pulvrigem Aluminiumoxid, Bornitrid oder einer ähnlichen hoch wärmeleitfähigen anorganischen Verbindung aufweisen. Beide Materialarten können zusätzlich Füllstoffe zur Feineinstellung der Verarbeitungs- und mechanischen Eigenschaften enthalten, beispielsweise hochdisperses Siliciumdioxid oder Silicate.

Die Härte des ausgehärteten Dichtungsprofils, gemessen nach dem Shore-Verfahren der Bestimmung der elastischen Eindringtiefe eine federbelasteten Prüfstiftes, (Shore A-Härte) liegt unterhalb von 90, bevorzugt unterhalb von 50.

Der Deformationsgrad eines fertigen U-förmigen Dichtungsprofils aus Vollmaterial kann (bezogen auf die Höhe des unbelasteten Profils) 30% oder mehr, für bestimmte Anwendungen bevorzugt bis über 50%, betragen. Durch spezielle Profilquerschnittsgestaltungen, etwa die Wahl eines zugleich kompressiblen und biegeverformbaren Lippenprofils, sind effektiver Deformationsgrad und Rückstellkraft des Dichtungsprofils zusätzlich gezielt beeinflußbar.

Durch die genannten materialseitigen und ggfs. zusätzlichen geometrischen Maßnahmen lassen sich auch Spalte mit über den Längsverlauf erheblich differierender Breite zuverlässig abschirmend bzw. mit ausreichender Wärmeübertragung abdichten. Dies erlaubt beispielsweise kostengünstig größere Toleranzen bei der Herstellung der Gehäuse für elektronische Geräte, bei denen es auf eine hochwirksame elektromagnetische Abschirmung funktionsentscheidend ankommt.

Vorteilhafte Weiterbildungen der Erfindung sind im übrigen in den Unteransprüchen gekennzeichnet bzw. werden nachstehend im Rahmen der Beschreibung bevorzugter Ausführungen der Erfindung unter Bezugnahme auf die Figuren näher dargestellt. Es zeigen:
- die Figuren 1a bis 1c: Schritte der Herstellung eines Abschirmgehäuses mit einem elektrisch leitfähigen Dichtungsprofil gemäß einer Ausführungsform,
- die Figuren 2a bis 2c: Schritte der Bildung eines leitfähigen Dichtungsprofils auf einem Gehäuseteil gemäß einer weiteren Ausführungsform und
- die Figuren 3a und 3b: Querschnittsdarstellungen von Dichtungsprofien als weitere Ausführungsbeispiele.

Als erstes Ausführungsbeispiel der Erfindung wird mit der nachfolgenden Tabelle als Mischung 1 ein elektrisch leitfähiges Dichtungsmaterial angegeben, das ein wärmehärtendes Einkomponentensystem darstellt und nach Aushärtung ein Abschirmdichtungsprofil mit einer Shore A-Härte von ca. 50 ergibt. Dieses nach dem Aushärten elastische, aber relativ weiche Material eignet sich für die Erzeugung von Abschirmprofilen an Gehäusekanten wiederverschließbarer EMI-Gehäuse mit mäßigen Fertigungstoleranzen.

### Mischung 1

| | | Anteil (Masse-%) |
|---|---|---|
| Komponente I | Silicon "TSE 3220" der Fa. GE | 13,6 |
| II | Polydimethylsiloxan mit Methyl- oder Hydroxylendgruppen (dyn. Visk. 20 ... 500 mPa.s) | 4,5 |
| III | Siliconharzlösung GE "PSA 529" | 8,2 |
| IV | Toluol | 6,8 |
| V | Benzin | 8,9 |
| VI | Ag-Pulver | 58,0 |

Als zweites Ausführungsbeispiel wird nachfolgend als Mischung 2 ein elektrisch leitfähiges Dichtungsmaterial angegeben, das ein raumtemperaturhärtendes Zweikomponentensystem darstellt und nach Aushärtung ein Abschirmdichtungsprofil mit einer Shore A-Härte von ca. 20 ergibt. Das aus diesem Material gebildete Abschirmprofil hat einen hohen Deformationsgrad, zeigt deutliche Plastizität und eignet sich besonders zum Abdichten von Spalten in EMI-Abschirmgehäusen mit erheblichen Fertigungstoleranzen.

### Mischung 2

| | | |
|---|---|---|
| Komponente I/A | Silicon GE "SLE 5300 A" | 14,44 |
| I/B | Silicon GE "SLE 5300 B" | 1,44 |
| II | Polydimethylsiloxan mit Methyl-endgruppen (Visk. ca. 50 mPa-s) | 5,6 |
| III | Toluol | 5,62 |
| IV | versilbertes Ni-Pulver | 72,9 |

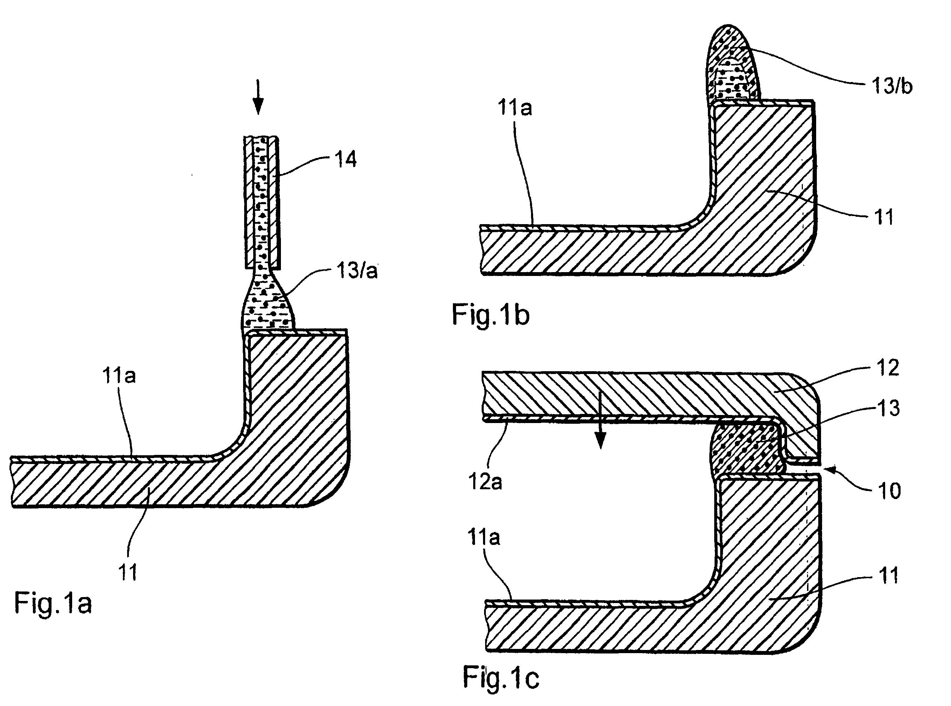

In den Figuren 1a bis 1c sind Schritte der Herstellung eines aus zwei Gehäuseteilen 11 und 12 bestehenden Abschirmgehäuses 10 mit einem elektrisch leitfähigen Dichtungsprofil 13 skizziert.

Auf das mit einer innenseitigen, die Gehäuseteilkante bedeckenden Metallisierung 11a versehene Gehäuseteil 11 wird in einem ersten, in Fig. 1a dargestellten Schritt aus einer Auftragsnadel 14 eine metallisch gefüllte Dichtungsmasse 13/a mit gelartiger Konsistenz (beispielsweise die obige Mischung 1 oder 2) extrudiert. Hierzu wird die Auftragsnadel 14 mittels eines (nicht dargestellten) koordinatengesteuerten Handhabungsgerätes relativ zum Gehäuseteil 11 in Richtung senkrecht zur Zeichenebene bewegt.

Wie in Fig. 1b zu erkennen ist, wird dadurch ein auf der Metallisierungsschicht 11a festhaftendes, annähernd U-förmiges Dichtungsprofil 13/b erzeugt, das nach dem Auftrag von der Oberfläche her - je nach konkreter Zusammensetzung - unter dem Einfluß der Luftfeuchtigkeit und/oder von Wärme (IR-Strahlung) und/oder einer UV- oder Gamma-Bestrahlung weitmaschig zu vernetzen begonnen hat.

Nach vollständiger Vernetzung zum fertigen Dichtungsprofil 13 (oder jedenfalls nach Vernetzung einer hinreichend dikken Oberflächenschicht) wird - wie Fig. 1c zeigt - senkrecht von oben das in seiner Kantengestaltung auf die unbelastete Form des Dichtungsprofils 13 abgestimmte zweite Gehäuseteil 12 aufgesetzt und (durch hier nicht dargestellte Mittel) mit dem ersten Gehäuseteil 11 verbunden. Dabei wird das Dichtungsprofil 13 auf etwa die Hälfte seiner ursprünglichen Höhe zusammengedrückt und schmiegt sich aufgrund seiner geringen Härte eng und unter Entwicklung relativ geringer Rückstellkraft an die Metallisierungsschichten 11a bzw. 12a der Gehäuseteile 11, 12 an, ohne allerdings an diesen anzuhaften. Dies gewährleistet einerseits eine hochwirksame Kantenabdichtung und -abschirmung, auch bei sich über die Gehäuselänge und u.U. auch während der Gebrauchsdauer des Gehäuses 10 erheblich änderndem Spaltmaß. Andererseits läßt sich das Gehäuse zu Wartungs- oder Reparaturzwecken ohne Zerstörung der Dichtung und Abschirmung 13 öffnen und wieder verschließen.

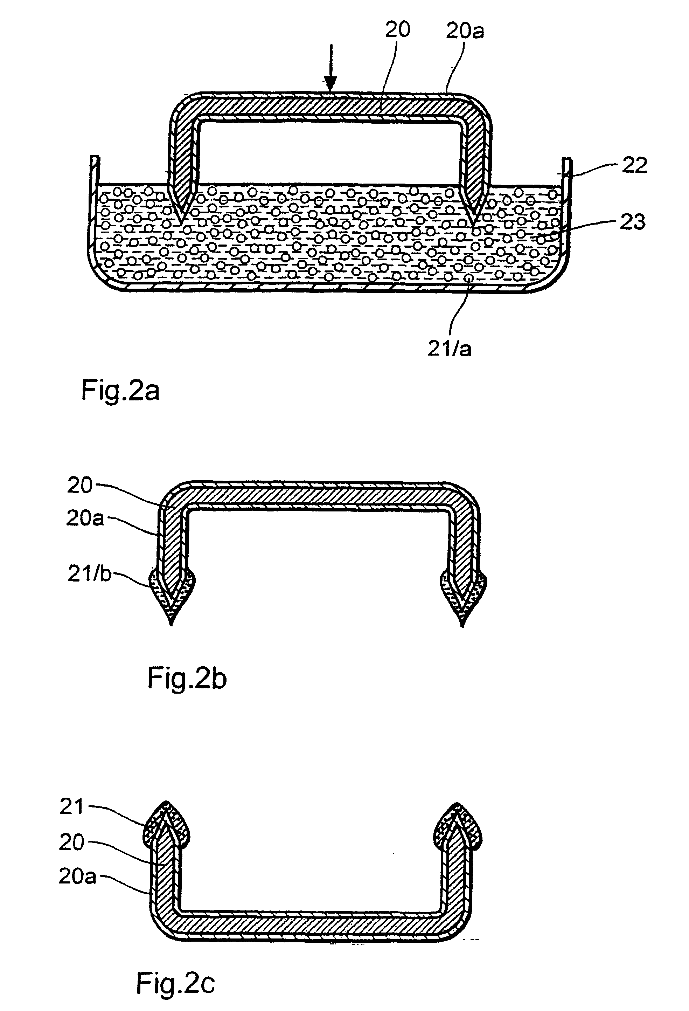

In den Figuren 2a bis 2c sind Schritte der Bildung eines leitfähigen Dichtungsprofils 21 auf einem Gehäuseteil 20 mittels eines Eintauchverfahrens skizziert.

In einem Behälter 22 befindet sich ein in einem organischen Lösungsmittel 23 stark verdünntes metallgefülltes Dichtungsmaterial 21/a auf Silicon-Siliconöl-Basis. Wie in Fig. 2a dargestellt, wird der V-förmige Kantenbereich des mit einer geschlossenen Oberflächenmetallisierung 20a versehenen Gehäuseteiles 20 in die Lösung eingetaucht.

Nach Herausziehen aus der Lösung 23 und Verdunsten des Lösungsmittelanteils haftet am Gehäuseteil eine Schicht 21/b aus dem Dichtungsmaterial, das in dieser Phase gemäß Fig. 2b eine pastös-gelartige Konsistenz hat und von der Oberfläche her durch Vernetzung der vernetzbaren Siliconkomponente auszuhärten beginnt.

Wie anhand von Fig. 2b und 2c leicht einzusehen, kann die endgültige Gestalt des Dichtungsprofils 21 durch Drehung des Gehäuseteils 20 um einen vorbestimmten Winkel zu einem vorbestimmten Zeitpunkt vor dem Durchhärten gesteuert werden, da sich die Form unter dem Einfluß der Schwerkraft G ausbildet. Bei einer Überführung in die in Fig. 2c gezeigte Lage erst nach teilweiser Aushärtung des Volumens wird sich ein größeres Teilvolumen der Dichtungsmasse an der (gemäß Fig. 2b unten liegenden) Spitze des "V" angesammelt haben als bei einem frühzeitigen Umdrehen des Gehäuseteiles 20.

Es ist leicht einsehbar, daß ein analoger Effekt auch bei anderer Gestalt des Kantenabschnitts auftritt. So wird sich in einem Ü- oder V-förmig genuteten Oberflächenbereich ein umso größerer Teil des Dichtungsvolumens im Bereich des Nutbodens bilden, je früher im Zuge der fortschreitenden Vernetzung des Gehäuseteil umgedreht wird.

Der durch eine Orientierungsänderung der Unterlage relativ zur Schwerkraftrichtung erreichbare Effekt kann weiterhin nicht nur im Rahmen eines Tauch-Auftragsverfahrens ausgenutzt werden, sondern in ähnlicher Weise bei einer aufextrudierten oder aufgesprühten Dichtung.

Durch Drehen des Gehäuseteils um einen von 180° verschiedenen Winkel nach dem Herausziehen aus der Lösung kann gezielt ein schiefwinkliges bzw. lippenförmiges Profil erzeugt werden, bei dem leicht eine Biegeverformung möglich ist.

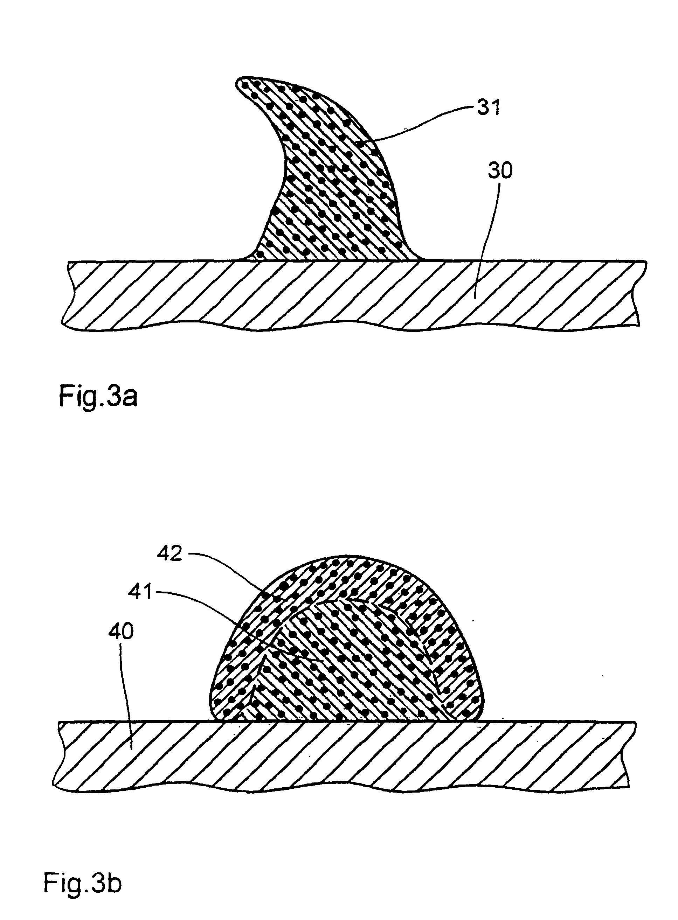

Eine solche Profilgestalt, wie sie in Fig. 3a am Querschnitt eines Abschirmprofils 31 auf einem ebenen Gehäuseabschnitt 30 schematisch dargestellt ist, bietet zusätzliche Freiheitsgrade bei der Optimierung von Deformierbarkeit und Formbeständigkeit.

In Fig. 3b ist eine weitere Fortbildung des Erfindungsgedankens skizziert. Auf einem Gehäuseabschnitt 40 wird zunächst ein erstes Teilprofil 41 mit sehr gutem Haftvermögen, geringer Härte und gewisser Plastizität (beispielsweise aus einer Siliconmischung ähnlich der oben angegebenen Mischung 2) erzeugt. Anschließend wird aus einem mit dem Material des ersten Teilprofils 41 kompatiblen Material (etwa einer Mischung mit geringerem Anteil nicht-vernetzender Siloxane oder ganz ohne solche) ein das erste Teilprofil 41 überdeckendes zweites Teilprofil 42 mit größerer Elastizität und Härte gebildet.

Beide Profilteile 41, 42 zusammen ergeben eine einerseits relativ weiche und hochgradig deformierbare und andererseits widerstandsfähige Abschirmdichtung, speziell für häufig zu öffnende und wieder zu schließende Abschirmgehäuse.

Die Erfindung beschränkt sich in ihrer Ausführung nicht auf die vorstehend angegebenen bevorzugten Ausführungsbeispiele. Vielmehr ist eine Vielzahl von Varianten denkbar, welche von der dargestellten Lösung im Rahmen der anhängendn Ansprüche auch bei anders gearteten Ausführungen Gebrauch machen.

## Patentansprüche

1. Leitfähiges Dichtungsmaterial (13/a; 21/a) auf Siliconkautschuk-Basis, insbesondere zur An-Ort-und-Stelle-Formung eines Dichtungsprofils (13; 21; 31; 41, 42), mit einem vernetzbaren Silicon und einem metallischen und/oder einem anorganischen Füllstoff, **gekennzeichnet durch** einen Anteil von mehr als 1 Masse-% langkettigem, nicht oder schwach vernetzendem Siloxan, wobei das Dichtungsmaterial nach dem Aushärten ein Dichtungsprofil mit einer shore A-Härte von gleich oder weniger als 90 ergibt.

2. Dichtungsmaterial nach Anspruch 1, **gekennzeichnet durch** einen Anteil des nicht oder schwach vernetzenden Siloxans von mehr als 3 Masse-%.

3. Dichtungsmaterial nach Anspruch 1 oder 2, **gekennzeichnet durch** einen Anteil von mehr als 3 Masse-% eines organischen Lösungsmittels.

4. Dichtungsmaterial nach einem der vorhergehenden Ansprüche, **gekennzeichnet durch** einen Anteil von mehr als 3 Masse-% einer Lösung eines vernetzbaren Siliconharzes.

5. Dichtungsmaterial nach Anspruch 1, 3 oder 4, **dadurch gekennzeichnet, daß** der Anteil des nicht oder schwach vernetzenden Siloxans und/oder des organischen Lösungsmittels den Anteil des vernetzbaren Silicons übersteigt und das Dichtungsmaterial flüssig ist.

6. Dichtungsmaterial nach einem der vorhergehenden Ansprüche, **gekennzeichnet durch** einen Anteil von mehr als 25, bevorzugt von mehr als 50, Masse-% eines elektrisch hoch leitfähigen pulvrigen metallischen Füllstoffs, insbesondere aus Silber oder versilbertem Kupfer oder Nickel.

7. Dichtungsprofil (13; 21; 31; 41, 42), das freitragend durch Aufbringen eines Dichtungsmaterials nach einem der Ansprüche 1 bis 6 auf eine zu dichtende Fläche und anschließendes Aushärten gebildet ist, **gekennzeichnet durch** eine Shore A-Härte von gleich oder weniger als 90.

8. Dichtungsprofil nach Anspruch 7, **gekennzeichnet, durch** eine Shore A-Härte von weniger als 50.

9. U-förmiger Dichtungsprofil aus Vollmaterial (13; 21; 31; 41, 42), das freitragend durch Aufbringen eines Dichtungsmaterials nach einem der Ansprüche 1 bis 6 auf eine zu dichtende Fläche und anschließendes Aushärten gebildet ist, **gekennzeichnet durch** einen Deformationsgrad von. über 30%, bezogen auf die Höhe des unbelasteten U-förmigen Dichtungsprofils aus Vollmaterial.

10. Dichtungsprofil nach Anspruch 9, **gekennzeichnet durch** einen Deformationsgrad von über 50%.

11. Dichtungsprofil nach einem der Ansprüche 7 bis 10, **dadurch gekennzeichnet, daß** es durch Extrudieren ohne zusätzlichen Formgeber hergestellt ist.

12. Dichtungsprofil nach einem der Ansprüche 7 bis 10, **dadurch gekennzeichnet, daß** es durch Tauchen der zu dichtenden Fläche in flüssiges Dichtungsmaterial (23, 21/a) und anschließendes formprägendes Aushärten in vorbestimmter Orientierung zur Schwerkraft (G) hergestellt ist.

13. Dichtungsprofil nach einem der Ansprüche 7 bis 12, **gekennzeichnet durch** eine bezüglich der Normalen auf die Unterlage (30) am Ort des Anhaftens an dieser unsymmetrische Querschnittsform, insbesondere Lippenform (31).

14. Dichtungsprofil nach einem der Ansprüche 7 bis 13, **gekennzeichnet durch** die Ausbildung aus einem ersten leitfähigen Profilteil (41) mit geringerer Shore A-Härte und höherer Deformierbarkeit und einem zweiten, mit dem ersten festhaftend verbundenen leitfähigen Profilteil (42) mit größerer Shore A-Härte und geringerer Deformierbarkeit.

## Claims

1. Conductive sealing material (13/a; 21/a) based on silicon rubber, particularly for forming a sealing profile (13; 21; 31; 41, 42) *in situ*, having a crosslinkable silicon and a metallic and/or inorganic filler, **characterised in that** it contains more than 1% by mass of long-chained uncrosslinked or slightly crosslinked siloxane, the sealing material producing, after curing, a sealing profile with a Shore A hardness of less than or equal to 90.

2. Sealing material according to claim 1, **characterised in that** it contains an amount of more than 3% by mass of the uncrosslinked or slightly crosslinked siloxane.

3. Sealing material according to claim 1 or 2, **characterised in that** it contains an amount of more than 3% by mass of an organic solvent.

4. Sealing material according to one of the preceding claims, **characterised in that** it contains an amount of more than 3% by mass of a solution of a crosslinkable silicon resin.

5. Sealing material according to claim 1, 3 or 4, **characterised in that** the amount of uncrosslinked or slightly crosslinked siloxane and/or organic solvent exceeds the amount of crosslinkable silicon and the sealing material is liquid.

6. Sealing material according to one of the preceding claims, **characterised in that** it contains an amount of more than 25, preferably more than 50% by mass of an electrically highly conductive powdered metal filler, particularly of silver or silver-plated copper or nickel.

7. Sealing profile (13; 21; 31; 41, 42) which is formed in overhanging manner by applying a sealing material according to one of claims 1 to 6 to a surface which is to be sealed and subsequently curing it, **characterised by** a Shore A hardness of less than or equal to 90.

8. Sealing profile according to claim 7, **characterised by** a Shore A hardness of less than 50.

9. U-shaped sealing profile of solid material (13; 21; 31; 41, 42) which is formed in overhanging manner by applying a sealing material according to one of claims 1 to 6 to a surface which is to be sealed and subsequently curing it, **characterised by** a degree of deformation of more than 30% based on the height of the unstressed U-shaped sealing profile of solid material.

10. Sealing profile according to claim 9, **characterised by** a degree of deformation of more than 50%.

11. Sealing profile according to one of claims 7 to 10, **characterised in that** it is produced by extrusion without additional forming means.

12. Sealing profile according to one of claims 7 to 10, **characterised in that** it is produced by dipping the surface which is to be sealed in liquid sealing material (23, 21/a) and then curing it, with shaping, in a predetermined orientation with respect to gravity (G).

13. Sealing profile according to one of claims 7 to 12, **characterised by** a non-symmetrical cross-sectional shape, particularly a lip shape (31), relative to the normal to the substrate (30) at the site of application.

14. Sealing profile according to one of claims 7 to 13, **characterised by** the formation of a first conductive profile member (41) with a lower Shore A hardness and higher deformability and a second conductive profile member (42) securely bonded to the first, with a greater Shore A hardness and lesser deformability.

## Revendications

1. Matériau d'étanchement conducteur (13/a ; 21/a) à base de caoutchouc au silicone, en particulier pour la mise en forme sur place d'un profilé d'étanchement (13 ; 21 ; 31 ; 41, 42), comprenant un silicone capable de réticuler et une matière de remplissage métallique et/ou une matière de remplissage inorganique, **caractérisé par** une proportion supérieure à 1 % de siloxane à chaîne longue non capable de réticuler ou faiblement capable de réticuler, ledit matériau d'étanchement produisant après durcissement un profilé d'étanchement avec une dureté Shore A égale ou inférieure à 96.

2. Matériau d'étanchement selon la revendication 1, **caractérisé par** une proportion de siloxane non capable de réticuler ou faiblement capable de réticuler supérieure à 3 % en masse.

3. Matériau d'étanchement selon l'une ou l'autre des revendications 1 et 2, **caractérisé par** une proportion de plus de 3 % en masse d'un solvant organique.

4. Matériau d'étanchement selon l'une des revendications précédentes, **caractérisé par** une proportion de plus de 3 % en masse d'une solution d'une résine au silicone capable de réticuler.

5. Matériau d'étanchement selon l'une des revendications 1, 3 et 4, **caractérisé en ce que** la proportion du siloxane non capable de réticuler ou faiblement capable de réticuler et/ou du solvant organique dépasse la proportion du silicone capable de réticuler, et **en ce que** le matériau d'étanchement est liquide.

6. Matériau d'étanchement selon l'une des revendications précédentes, **caractérisé par** une proportion supérieure à 25 %, de préférence supérieure à 50 % en masse d'un produit de remplissage métallique poudreux fortement conducteur de l'électricité, en particulier en argent, ou en cuivre ou en nickel argenté.

7. Profilé d'étanchement (13 ; 21 ; 31 ; 41, 42) qui a été formé de manière autoportante par application d'un matériau d'étanchement selon l'une des revendications 1 à 6 sur une surface à étancher et par durcissement successif, **caractérisé par** une dureté Shore A égale ou inférieure à 90.

8. Profilé d'étanchement selon la revendication 7, **caractérisé par** une dureté Shore A inférieure à 50.

9. Profilé d'étanchement en forme de U en matériau plein (13 ; 21 ; 31 ; 41, 42) qui a été formé de manière autoportante par application d'un matériau d'étanchement selon l'une des revendications 1 à 6 sur une surface à étancher et par durcissement successif, **caractérisé par** un taux de déformation supérieur à 30 %, en se référant à la hauteur du profilé d'étanchement en forme de U en matériau plein non sollicité.

10. Profilé d'étanchement selon la revendication 9, **caractérisé par** un taux de déformation supérieur à 50 %.

11. Profilé d'étanchement selon l'une des revendications 7 à 10, **caractérisé en ce qu'**il a été réalisé par extrusion sans moyens additionnels de conformation.

12. Profilé d'étanchement selon l'une des revendications 7 à 10, **caractérisé en ce qu'**il a été réalisé par plongée de la surface à étancher dans un matériau d'étanchement liquide (23, 21/a) et par durcissement successif et conformation dans une orientation prédéterminée par rapport à la gravité (G).

13. Profilé d'étanchement selon l'une des revendications 7 à 12, **caractérisé par** une forme de section transversale asymétrique par rapport à la perpendiculaire à la face de support (30) à l'emplacement d'adhérence sur celle-ci, en particulier une forme de lèvre (31).

14. Profilé d'étanchement selon l'une des revendications 7 à 13, **caractérisé par** la réalisation d'une première partie de profilé conductrice (41) avec une dureté Shore A plus faible et une capacité de déformation supérieure, et d'une seconde partie de profilé conductrice (42) reliée de manière ferme par adhésion à la première, avec une dureté Shore A plus élevée et une capacité de déformation inférieure.
